Europäisches Patentamt

European Patent Office

Office européen des brevets

(11) Publication number: **0 070 602**
A1

(12) **EUROPEAN PATENT APPLICATION**

(21) Application number: 82200900.7

(51) Int. Cl.³: **G 01 R 13/40**, G 02 F 1/133

(22) Date of filing: **15.07.82**

(30) Priority: **21.07.81 NL 8103435**

(43) Date of publication of application: **26.01.83**
**Bulletin 83/4**

(84) Designated Contracting States: **DE FR GB IT**

(71) Applicant: **N.V. Philips' Gloeilampenfabrieken,**
**Groenewoudseweg 1, NL-5621 BA Eindhoven (NL)**

(72) Inventor: **Schneider, Henri Willem, c/o**
**INT.OCTROOIBUREAU B.V. Prof.Holstlaan 6,**
**NL-5656 AA Eindhoven (NL)**

(74) Representative: **Schneider, Henri Willem et al,**
**INTERNATIONAAL OCTROOIBUREAU B.V. Prof.**
**Holstlaan 6, NL-5656 AA Eindhoven (NL)**

(54) **Multi-channel oscilloscope comprising a liquid crystal display screen.**

(57) In an oscilloscope comprising a liquid crystal matrix display screen 10 for simultaneously displaying two or more phenomena with a high resolution, the display quality is optimized when control is effected in time-division multiplex with a time-division multiplex ratio equal to the number of rows $\underline{n}$, by choosing the ratio $\underline{a}$ of the row selection pulses $V_s$ and the column excitation pulses $V_k$ at least equal to $\sqrt{2}$. The best approximation for a p-channel oscilloscope for displaying $\underline{p}$ phenomena is obtained with $\underline{a} = \sqrt{p}$, a good approximation for $\underline{p} \leqslant 8$ with $\underline{a} = 2$.

"Multi-channel oscilloscope comprising a liquid crystal display screen."

The invention relates to an oscilloscope for displaying a plurality of $p$ curves ($p > 1$), comprising a display screen incorporating a liquid crystal of the root-mean-square type and a matrix excitation circuit, the display screen being provided at one side in a manner which is known per se with a plurality of line-shaped first excitation electrodes and at the other side with a plurality of second excitation electrodes crossing the first excitation electrodes and a portion of the liquid crystal located between two crossing electrodes forming a display element, the matrix excitation circuit comprising a row selection circuit for sequentially and cyclically exciting one of the first excitation electrodes by means of a d.c. voltage row selection pulse while a common quiescent voltage is applied to all the other first excitation electrodes, and a column excitation circuit for displaying a picture element by means of a display element, the column excitation circuit supplying the second excitation electrode, which corresponds to the display element, with the common quiescent voltage on which excitation pulses have been superposed simultaneously or substantially simultaneously with the row selection pulses for the first excitation electrode which corresponds with the display element.

Such oscilloscopes are used for the simultaneous display of two or more phenomena represented by electric voltages, particularly if the very low current consumption of a liquid crystal display screen is important, as, for example, in battery-fed apparatus.

An oscilloscope of the above described type is disclosed in Netherlands Patent Application No. 7809081.

Said Patent Application describes an oscilloscope which uses a very simple pulse drive of row and column conductors of the display screen in a time-division multiplex control, in such a manner that it is possible to obtain an adequate contrast, even at a large number of rows $n$ for simultaneously displaying 2 or 3 phenomena.

If said arrangement is provided with a liquid crystal having a steeper contrast-versus-voltage curve near the threshold voltage of the liquid crystal, as they are now available, a maximum of 5 curves can be displayed with an acceptable contrast.

For some uses, for example measurements on complicated circuits, it is necessary that eight or more curves are displayed simultaneously.

The invention has for its object to provide means with which it is possible to display in a cheap manner approximately twice the number of curves or to display the same or a somewhat higher number of curves simultaneously with a good contrast. The difference between a good and an acceptable contrast is inter alia expressed in the wider angle of incidence with which the image can be visually observed.

According to the invention, an oscilloscope is therefore characterized in that the amplitude of the row selection pulses is substantially a factor $a$ greater than the amplitude of the excitation pulses, $a$ being at least equal to $\sqrt{2}$.

It then appears that when the amplitude of the selection pulses is increased relative to the amplitude of the excitation pulses, the electric contrast increases in the first instance. The electric contrast K is here understood to mean the ratio between $\hat{V}_{ON}$ and $\hat{V}_{OFF}$. In conformity with the description in the cited Patent Application it is defined that

$$K_+ = \frac{\hat{V}_{ON}}{\hat{V}_{OFF}}$$

for the event that the two types of pulses have the same polarity.

0070602

In the other event $\hat{V}_{OFF} > \hat{V}_{ON}$ so that now it is preferred to define .

$$K_- = \frac{\hat{V}_{OFF}}{\hat{V}_{ON}} ,$$

so that for both cases K becomes larger than 1 and a larger K means a higher contrast.

The visual contrast on the display screen always increases versus an increasing K; the value of the visual contrast depends of course, on the shape of the voltage-versus-contrast curve which is characteristic for the type of liquid crystal used.

It further appears that K has a rather flat maximum if the RMS a.c. voltages on first and second excitation conductors are approximately equal, which is obtained if $\underline{a}$ is chosen to be approximately equal to $\sqrt{p}$.

An advantageous embodiment of an oscilloscope in accordance with the invention is therefore characterized in that the oscilloscope further comprises an adjusting circuit for adjusting the factor $\underline{a}$ in dependence on the chosen value of $\underline{p}$, in such a manner that $\underline{a}$ is substantially equal to $\sqrt{\underline{p}}$.

As the above-mentioned maximum is not very pronounced, the advantage aimed at is almost fully accomplished with a constant value of $\underline{a}$, which results in a somewhat simpler and cheaper solution.

Therefore, a further advantageous embodiment is characterized in that the choice $\underline{a}$ is approximately equal to 2.

The ratio of the pulse amplitudes can be realized in different manners, which are known per se.

The simplest and cheapest manner is to drive all excitation electrodes by means of, for example, gate circuits or logic inverter circuits, whereby the generated pulse amplitudes become approximately equal to the supply voltages used for the circuits.

A practical embodiment of an oscilloscope in accordance with the invention is therefore characterized in that the oscilloscope comprises a supply circuit for producing at least two mutually different supply voltages, in such a manner that at least all output circuits for driving the first excitation electrodes are supplied with a supplyvoltage which is substantially a factor $a$ greater than the supply voltage for the output circuits for driving the second excitation electrodes.

The invention will now be further described by way of example with reference to the accompanying drawings. In the drawings:

Fig. 1 is a time diagram of the voltages across a selected display element in row 8 and column x;

Fig. 2 is a graph showing the relationship between the electric contrast K and the number of curves $p$ to be displayed, the factor $a$ having been chosen as a parameter, and

Fig. 3 shows a simplified block diagram of an oscilloscope in accordance with the present invention.

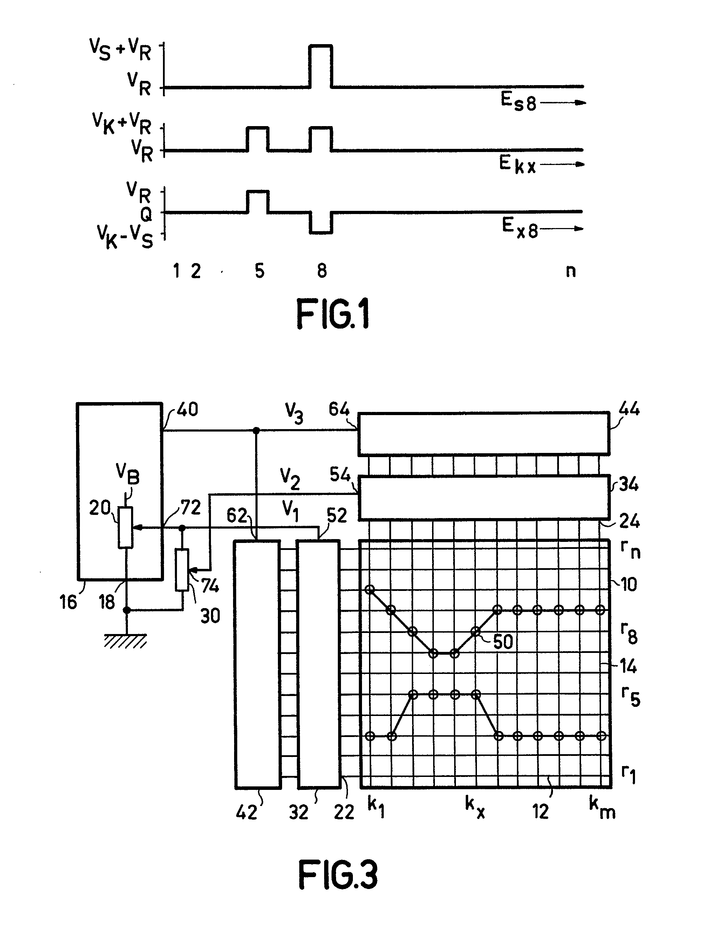

In Fig. 1, the top row shows the variation of the electric voltage versus the time for an entire picture cycle of $n$ selection periods, corresponding to $n$ first excitation conductors and consequently to $n$ lines, the voltage $E_{s8}$ being chosen by way of example, that is to say the voltage applied to the eighth line.

With a view to a sufficient resolution, $n$ will usually be chosen between 50 and 500. The same holds for the number of columns $m$, it being possible that $m$ and $n$ are different which is not important for the invention.

$E_{s8}$ has one pulse with amplitude $V_S$ during the eighth selection period and is further equal to a quiescent voltage $V_R$.

The central line shows the voltage variation $E_{kx}$ on a second excitation conductor $x$, wherein $1 \leqslant x \leqslant m$. By way of example it is chosen that for each column two picture elements must be displayed, in these columns in the places 5 and 8, for which purpose $E_{kx}$ shows pulses having an amplitude $V_k$, which pulses coincide in the time with the $5^{th}$ and $8^{th}$ selection pulses, respectively. So in this example $p = 2$.

Finally, the bottom line shows the electric voltage $E_{x8}$ across the display element in the point where column x crosses row 8, it then being that $E_{x8} = E_{kx} - E_{s8}$.

As also the column excitation voltage has the quiescent value $V_R$, $V_R$ plays no part in the voltage across the display elements.

Usually $V_R$ is determined by the residual collector voltage of a fully driven transistor and has then a value of some tenths of a volt.

The entire pattern is repeated in each full picture cycle, for example 25 times per second.

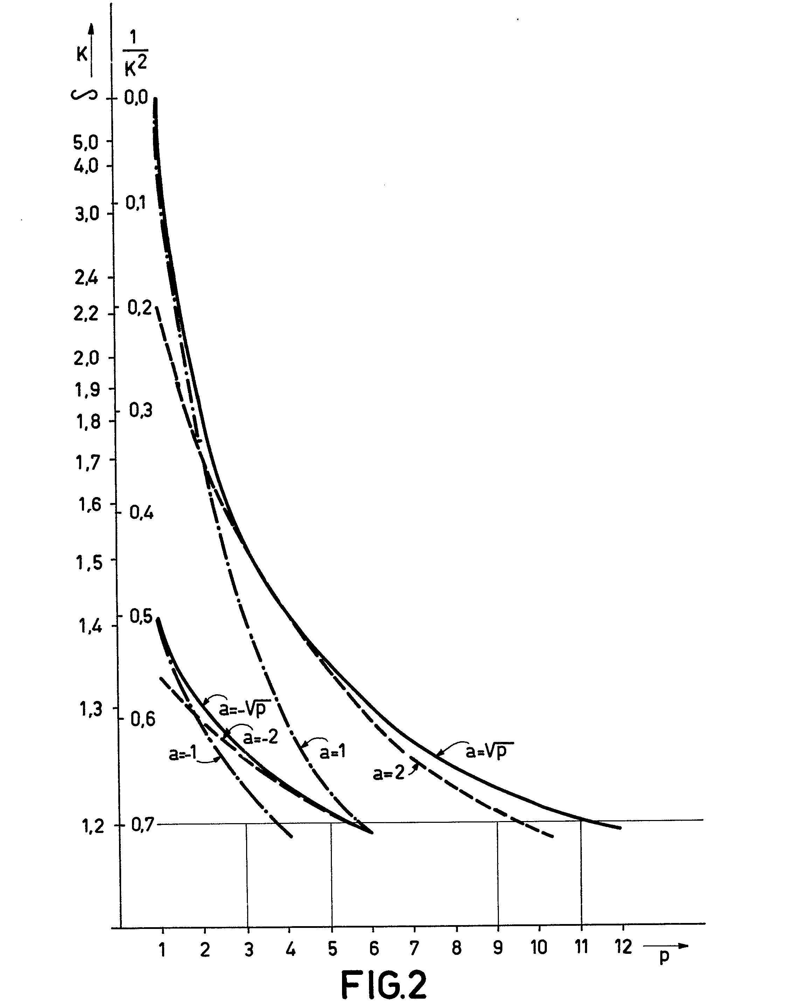

Fig. 2 shows the values which are obtained for K for every value chosen for $p$, each time for six values of the parameter $a$. The three extreme right-hand lines result in positive values of $a$, that is to say row and column excitation pulses have the same polarity.

The three left-hand bottom lines correspond to negative values of $a$. The two dot-dash lines with $a = + 1$ and $a = -1$ correspond to the K-values of the oscilloscope described in the cited patent application.

The horizontal line for $K = 1.2$ defines the limit in modern liquid crystals at which an acceptable visual contrast can still be obtained.

Irrespective of the value of the time-division multiplex factor $n$ a display up to a maximum of 11 curves is possible with an acceptable contrast.

It is alternatively possible to increase the electric contrast in, for example, a four-channel oscilloscope from approximately $K = 1.29$ to approximately $K = 1.42$, whereby the visual contrast is considerably improved, particularly when the screen is observed at a wide angle of incidence.

The graphs clearly show that the differences between $a = \sqrt{p}$ and $a = 2$ are hardly important for values

of $p \leqslant 8$. The choice $\underline{a} = 2$ allows however the omission of one adjusting means.

In the case that $\underline{p} = 2$, corresponding with the frequently occurring type of dual-channel oscilloscope, the choice $\underline{a} = 2$ does not seem to furnish in the first instance any advantage, as $\underline{a} = 1$ and $\underline{a} = 2$ result in the same K-value.

However, in this case there is an other advantage, as can be explained with reference to Fig. 1. If $V_S = 2 V_K$, then it is obtained therewith that $V_K - V_S = -V_K$. As will be apparent from the bottom graph in Fig. 1 it appears that the mean d.c. voltage for the displaying picture element then becomes equal to zero. For a non-displaying element two pulses are then found, one pulse having a value $+V_K$ and one having a value $-2V_K$, so that the mean d.c. voltage is also equal to zero. This is necessary to ensure a sufficiently long operating life of the liquid crystal.

When liquid crystals are driven otherwise than with, for example, two-frequency drive, it is necessary, because of the residual d.c. voltage components, to reverse the polarity of all voltages periodically in a manner which is known per se. Usually, pole reversal with half a period equal to one picture cycling period will than be opted for. No pole reversal is required in the event that $\underline{p} = 2$ and $\underline{a} = 2$, so that this embodiment becomes simpler and cheaper than the original embodiment wherein $\underline{a} = 1$, while the high electric contrast with K = 1.75 is maintained.

Fig. 3 shows in a practical implementation by means of a simplified block diagram the elements which are essential to the invention, $V_S$ and $V_K$ having the same sign. Whether these signs are both positive or both negative is not important for the invention. This choice only depends on the semiconductor technology chosen for the implementation.

A matrix display screen 10 is schematically shown

with $\underline{n}$ first excitation conductors 12, or row conductors $r_1$ to $r_n$, inclusive and $\underline{m}$ second excitation conductors 14 or column conductors $k$ to $k_m$, inclusive.

The first excitation conductors 12 are connected to corresponding outputs 22 of a row selection circuit 32, 42, the implementation whereof corresponds to, for example, one of the embodiments described in the above-cited patent application.

The portion 32 of the row selection circuit comprises at least those elements of the row selection circuit that provide output signals on which are directly connected to a row conductor $r_{ij}$, for example a last excitation inverter circuit, the last flip-flop in the control of that row conductor or even only that transistor of the flip-flop the collector or source of which constitutes the output 22. All the remaining elements of the row selection circuit must be considered as being incorporated in the block 42.

The groups of elements 32, 42 each have a terminal 52 and 62, respectively for their respective supply voltages.

In a corresponding manner the second excitation conductors 14 are coupled to input 24 of a column excitation circuit 34, 44 having corresponding supply voltage terminals 54 and 64, respectively.

The supply voltage terminals 52, 62, 54 and 64 receive their supply voltages from a supply circuit 16, one pole, for example pole 18, whereof is connected to the common return conductor of the oscilloscope, which is usually designated "ground", although a specific ground conductor is usually not necessary and sometimes even unwanted.

A supply output 72 of the supply circuit 16 is connected to the supply voltage terminal 52 of the portion 32 of the row selection circuit and applies thereto a voltage $V_1 = V_S + V_R$ which can be adjusted by means of a control circuit, for example a potentiometer.

Between the poles 18 and 72 of the supply circuit 16 there is a potentiometer 30 the tap 74 of which is connected to the supply voltage terminal 54 of the portion 34 of the column excitation circuit 34, 44, for producing a supply voltage $V_2 = V_k + V_R$, the potentiometer 30 being adjusted such that $V_K = V_S/\underline{a}$, wherein it holds, for example, that $\underline{a} = \sqrt{p}$.

In the event that the approximation with $\underline{a} = 2$ is opted for, the potentiometer 30 may be replaced by a series arrangement of two fixed resistors of approximately equal resistance values, having a tapping point 74.

The remaining portions of the control circuit 42 and 44 are generally supplied with an optimum logic-operating voltage $V_3$. For that purpose, their supply voltage terminals 54 and 64, respectively are connected to a further output 40 of the supply circuit 16. However, the supply of power to the remaining circuit elements is not important for achieving the object of the invention. It is in principle alternatively possible to supply the portions 42 and 44 with supply voltages $V_1$ or $V_2$.

If the output transistors of the portions 32 and 34 are driven fully to saturation or are even over-driven, then the outputs 22 will vary between the voltages $V_R$ and $V_R + V_S$, and the outputs 24 between $V_R$ and $V_R + V_K$, in conformity with Fig. 1, wherein $V_R$ is then equal to the collector quiescent voltage $V_{co}$ of a saturated transistor.

Partly because the value of $\underline{a}$ does not have close tolerances, and because $V_{co}$ is low relative to $V_K$, it is also possible to take as a good approximation $V_S = V_1$ and $V_K = V_2$.

The display element 50 at the point where $k_x$ and $r_8$ intersect is part of a curve. In accordance with Fig. 1, the rms value of the voltage $E_{x8}$ is then the voltage $\hat{V}_{OFF}$, as for the voltage $E_{x5}$. The remaining picture elements of the column $k_x$ have a voltage variation $E_{xy}$ with the rms value $\hat{V}_{ON}$.

0070602

In customary manner potentiometer 20 is adjusted so that $\hat{V}_{OFF}$ is approximately equal to the threshold voltage $V_{TH}$ of the liquid crystal used. This adjustment can be done automatically in a manner which is known per se in order to compensate for, for example, the temperature-dependance of $V_{TH}$.

The designation OFF in $\hat{V}_{OFF}$ has only an electric significance in that it is the lowest rms voltage which may be produced across a picture element. Whether the picture element is then seen as being in the ON or in the OFF condition depends on the chosen type of display screen. Elements carrying the rms voltage $\hat{V}_{OFF}$ may show as dark elements against a light background or the other way round. With twisted nematic display screens this depends on whether the two polarizers are crossed or not. This too is not important for the essence of the invention.

1.      An oscilloscope for displaying a plurality of p curves (p > 1), comprising a display screen incorporating a liquid crystal of the root-mean-square type and a matrix excitation circuit, the display screen being provided at one side in a manner which is known per se with a plurality of line-shaped first excitation electrodes and at the other side with a plurality of second excitation electrodes crossing the first excitation electrodes and a portion of the liquid crystal located between two crossing electrodes forming a display element, the matrix excitation circuit comprising a row selection circuit for sequentially and cyclically exciting one of the first excitation electrodes by means of a d.c. voltage row selection pulse while a common quiescent voltage is applied to all the other first excitation electrodes and a column excitation circuit for displaying a picture element by means of a display element, the column excitation circuits supplying the second excitation electrode, which corresponds to the display element, with the common quiescent voltage on which excitation pulses are superposed simultaneously or substantially simultaneously with the row selection pulses for the first excitation electrode which corresponds to the display element, characterized in that the amplitude of the row selection pulses is predominantly a factor a greater than the amplitude of the excitation pulses, a being at least equal to $\sqrt{2}$.

2.      An oscilloscope as claimed in Claim 1, characterized in that the oscilloscope further comprises an adjusting circuit for adjusting the factor a in dependence on the value chosen for p, in such a manner that a is substantially equal to $\sqrt{p}$.

3. An oscilloscope as claimed in Claim 1, characterized in that the oscilloscope is of such a construction that the factor $a$ has a fixed value, which value is substantially equal to 2.

4. An oscilloscope as claimed in any one of the preceding Claims, comprising a matrix excitation circuit comprising logic gate and inverter circuits, every first and every second excitation electrode being connected to a corresponding output circuit of the matrix excitation circuit, characterized in that the oscilloscope comprises a supply circuit for producing at least two mutually different supply voltages in such a manner that at least all the output circuits for driving the first excitation electrode are supplied with a supply voltage which is substantially a factor $a$ higher than the supply voltage for the output circuits for driving the second excitation electrodes.

FIG.1

FIG.3

15·07·82

0070602

FIG.2

# EUROPEAN SEARCH REPORT

European Patent Office

Application number

EP 82 20 0900

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A,D | GB-A-2 031 201 (PHILIPS) <br> * Page 2, lines 5-49 * & NL - A - 78 09081 | 1 | G 01 R 13/40 <br> G 02 F 1/133 |
| A | US-A-3 955 187 (J.E. BIGELOW) <br> * Abstract * | 1,2 | |
| A | US-A-4 117 472 (W.G. FREER et al.) <br> * Figure 5; column 5, lines 10-33 * | 1,3 | |

TECHNICAL FIELDS SEARCHED (Int. Cl. ³)

G 01 R
G 02 F

The present search report has been drawn up for all claims

| Place of search | Date of completion of the search | Examiner |
|---|---|---|
| THE HAGUE | 23-08-1982 | MIELKE W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82